Europäisches Patentamt

European Patent Office

Office européen des brevets

(19)

(11) Veröffentlichungsnummer: **0 248 236**
**A2**

(12) **EUROPÄISCHE PATENTANMELDUNG**

(21) Anmeldenummer: **87106767.4**

(22) Anmeldetag: **09.05.87**

(51) Int. Cl.⁴: **G11C 13/04**

(30) Priorität: **06.06.86 DE 3619155**
**25.04.87 DE 3713954**

(43) Veröffentlichungstag der Anmeldung:
**09.12.87 Patentblatt 87/50**

(84) Benannte Vertragsstaaten:
**AT BE CH FR GB IT LI NL**

(71) Anmelder: **Fried. Krupp Gesellschaft mit beschränkter Haftung**
**Altendorfer Strasse 103**
**D-4300 Essen 1(DE)**

(72) Erfinder: **Harris, Stephen, Dr.**
**Hamannstrasse 16**
**D-4030 Ratingen 8(DE)**
Erfinder: **Lorenzen, Claus-Jürgen, Dr.**
**Kocherstrasse 3**
**D-4300 Essen 18(DE)**
Erfinder: **Würzburger, Martin**
**Herm.-Albertz-Strasse 187**
**D-4200 Oberhausen 1(DE)**
Erfinder: **Hahn, Ulrich, Dr.**
**Mülheimer Strasse 42**
**D-4300 Essen 1(DE)**
Erfinder: **Bittner, Gerd**
**Am Schoolkamp 36**
**D-4250 Bottrop(DE)**
Erfinder: **Adolfs, Friedhelm**
**Angermunder Weg 52**
**D-4030 Ratingen(DE)**

(54) **Verfahren und Vorrichtung zur berührungslosen Datenübertragung.**

(57) Um Informationen von und zu einem reversiblen Speicher auf optischem Weg störunanfällig übertragen zu können, wird vorgeschlagen, die optischen Informationen in Form von Fourier-Hologrammen durch Laserlicht einzulesen und durch Reflektion herauszulesen.

Dieses Verfahren eignet sich insbesondere zur Kennzeichnung und Identifizierung von Werkzeugen und/oder Werkstücken.

EP 0 248 236 A2

Xerox Copy Centre

## Verfahren und Vorrichtung zur berührungslosen Datenübertragung

Die Erfindung betrifft ein Verfahren und eine Vorrichtung zur berührungslosen optischen Übertragung von Daten zwischen jeweiligen Sender-und Empfängerkombinationen, die eine Datenauswertung besitzen, und einen nicht flüchtigen passiven reversiblen Speicher. Insbesondere sind das Verfahren bzw. die Vorrichtung zur Kennzeichnung und Identifizierung von Werkzeugen und/oder Werkstücken geeignet.

Es ist nach dem Stand der Technik bekannt, daß die optischen Informationen durch Laserlicht in einen optisch aktivierbaren reversiblen Speicher eingelesen und durch Reflektion herausgelesen werden können. Mit anderen Worten, die zu übertragenden Daten werden mit Hilfe eines Laserstrahls im optischen Speicher fixiert, indem die physikalische oder chemische Struktur des Speichermediums unter dem Einfluß des Laserstrahls verändert wird. Diese Veränderung ist, gesteuert durch den Laser, reversibel. Das Auslesen der Daten geschieht wiederum durch Bestrahlen des Speichermediums mit Laserlicht, wobei eine Empfangseinrichtung die durch eine vorhergehende Programmierung geänderte Struktur der bestrahlten Fläche des Mediums registriert.

Dieses Verfahren ist gekennzeichnet durch die Unempfindlichkeit des Informationsträgers Licht für Störbeeinflussungen gegenseitiger als auch umweltbedingter Natur, ohne selbst die Umwelt durch elektromagnetische Störungen zu beeinflussen. Dadurch ist es möglich, in einer Vielzahl benachbarter Speichermodule gezielt mit einzelnen Modulen zu kommunizieren. Außerdem wird durch das optische Verfahren die Informationsübertragung durch das zu kennzeichnende Material, auf dem das Speichermodul angebracht ist, in keiner Weise störend beeinflußt.

Ein weiterer Vorteil ist die geringe Temperaturempfindlichkeit des rein passiven Speichermoduls gegenüber den auf aktiven elektronischen Bauteilen basierenden Kennzeichnungssystemen.

Dagegen wirkt es sich insbesondere bei der Kennzeichnung von Werkstücken und Werkzeugen ungünstig aus, daß die Information nicht redundant so abgespeichert wird, daß die einzelnen Speicherbereiche jeweils verschiedene Bestandteile der Information speichern. Bei einer teilweisen Verschmutzung oder Abdeckung des Speichers kann die Information nicht mehr vollständig zurückgewonnen werden. Außerdem können kleine Kennzeichnungen nur aus nächster Nähe gelesen werden.

Aufgabe der vorliegenden Erfindung ist daher ein optisches Verfahren, das unter Beibehaltung der bisherigen Vorteile optischer Verfahren die oben aufgeführten Mängel vermeidet.

Die Aufgabe wird erfindungsgemäß durch ein optisches Verfahren so gelöst, daß die Informationen im reversiblen Speicher in Form von Fourier-Hologrammen gespeichert werden. Bei Fourier-Hologrammen ist die teilweise Verschmutzung oder Überdeckung des reversiblen Speichers unschädlich und auch kleine Kennzeichnungsmarken können noch aus größerer Entfernung gelesen werden. Im einfachsten Fall kann die Information in den Fourier-Hologrammen in einer Vielzahl von Strichen unterschiedlicher Dicke und/oder Abstände codiert werden.

Die Speicherung ist im einfachsten Fall durch Bestrahlung des reversiblen Speichers mit raumfrequenzmoduliertem Laserlicht möglich. Die Modulation erfolgt mit Hilfe eines Referenzstrahles, der mit einem zweiten, dem informationstragenden Strahl auf der Speicheroberfläche überlagert wird. Die Informationen werden dem zweiten Strahl mit einem Dia, einem Transparent, einem Flüssigkristalldisplay oder einem Transmissions-Fourier-Hologramm eingeprägt.

Eine andere Vorrichtung zur Speicherung und zum Lesen der Hologramme besteht in diesem Fall aus einem optisch aktivierbaren, passiven, reversiblen Speichermodul sowie aus einer stationären Einheit, aufgebaut aus einem Laser mit Modulations-und Scannervorrichtungen und einem Empfänger zur Auswertung der vom Speichermodul abrufbaren Informationen.

Bevorzugt wird bei dieser Vorrichtung die aktivierbare Speicherfläche punktuell vom Laserlichtbündel bestrahlt, was dadurch gewährleistet werden kann, daß das die Information tragende Laserlichtbündel durch eine vor der aktiven Speicherfläche angeordnete, fokussierend wirkende Schicht geschickt wird. Die Fokussierung leisten bevorzugt eine Vielzahl von Linsen, wie insbesondere sphärische und/oder zylindrische Linsen, oder mehrere Schichten mit unterschiedlichen Brechungsindizes. Die Adressierung des Laserstrahlbündels in einer Richtung senkrecht zur Ausbreitungsrichtung wird bevorzugt durch eine Verschiebung des Laserstrahlbündels vorgenommen. Somit kann jeder Speicherplatz im Speichermedium mittels x-y-Ablenkung und Fokussierung gezielt angestrahlt und somit informationsübertragend ausgenutzt werden.

Nach einer Weiterbildung der Erfindung bietet sich die Speicherung der Fourier-Hologramme in Form von Weißlichthologrammen an.

Nach einer anderen Weiterbildung der Erfindung werden die Informationen in Form von Volumenhologrammen abgespeichert. Die transformierten Daten, die in ihrer Gesamtheit das Hologramm bilden, werden in diesem Fall durch räumliche Ablenkung des Laserlichts selektiv und punktuell in einem räumlichen Raster gespeichert. Hierzu bieten sich inbesondere akustooptische Deflektoren an.

Um jeden Speicherplatz optimal vom Laserstrahlbündel fokussiert anstrahlen zu können, wird eine Schicht mit unterschiedlicher Dicke und Brennweite vor dem Speicher angeordnet. Diese Schicht besteht vorzugsweise aus zusammenhängenden sphärischen und/oder zylindrischen Linsen.

Zur Registrierung der ausgelesenen transformierten Daten, die in ihrer Gesamtheit das Hologramm bilden, ist eine Vorrichtung vorgesehen, etwa ein Photoelement, eine Videokamera oder CCD-Bauelement.

Ausführungsbeispiele der Erfindung sind in den Zeichnungen dargestellt. Es zeigen

Fig. 1 eine schematische Darstellung eines Systems zur seriellen Speicherung von transformierten Daten,

Fig. 2 eine schematische Darstellung eines Systems zur parallelen Verarbeitung von Daten mit Holographietechnik.

Linksseitig der gestrichelten Linie 10 befindet sich die stationäre Sender-/Empfängerkombination, die im wesentlichen aus einem Laser 1, einem Modulator 3, einer Scannervorrichtung, bestehend aus Deflektor 4 und Scannerlinse 5, sowie aus einer Detektionsvorrichtung, aufgebaut aus den Komponenten Lochspiegel 7, Kollimatorlinse 8 und Photodetector 9. Rechtsseitig der Linie 10 befindet sich das optische Speichermodul 6.

Die zu speichernden Daten, die in ihrer Gesamtheit ein Hologramm bilden, werden mit Hilfe der Steuerung 2 und dem Modulator 3 dem im Laser 1 erzeugten Laserstrahl aufmoduliert. Die Adressierung der Speicherzellen im Speichermodul 6 erfolgt durch die Steuerung 2 über Ablenkung des sich in z-Richtung ausbreitenden modulierten Laserstrahls in x-/y-Richtung mittels des Deflektors 4 und der Scannerlinse 5. Zum Löschen und Schreiben des Speichermoduls 6 werden die Speicherzellen des Moduls in oben bechriebener Weise adressiert und mit dem durch den Modulator 3 intensitätsgesteuerten Laserstrahl aus dem Laser 1 bestrahlt.

Für den Lesevorgang wird das vom Speichermodul 6 remittierte Licht durch Scannerlinse 5 und Deflektor 6 durch den Lochspiegel 7 mit der Kollimatorlinse 8 auf den Photodetector 9 fokussiert, welcher die Intensitätsschwankungen des remittierten Lichts in elektrische Signale umsetzt, die in der Steuerung in binäre Daten gewandelt werden.

Der oben beschriebene Lesevorgang dient auch der Funktionskontrolle beim Speicher-und Löschvorgang.

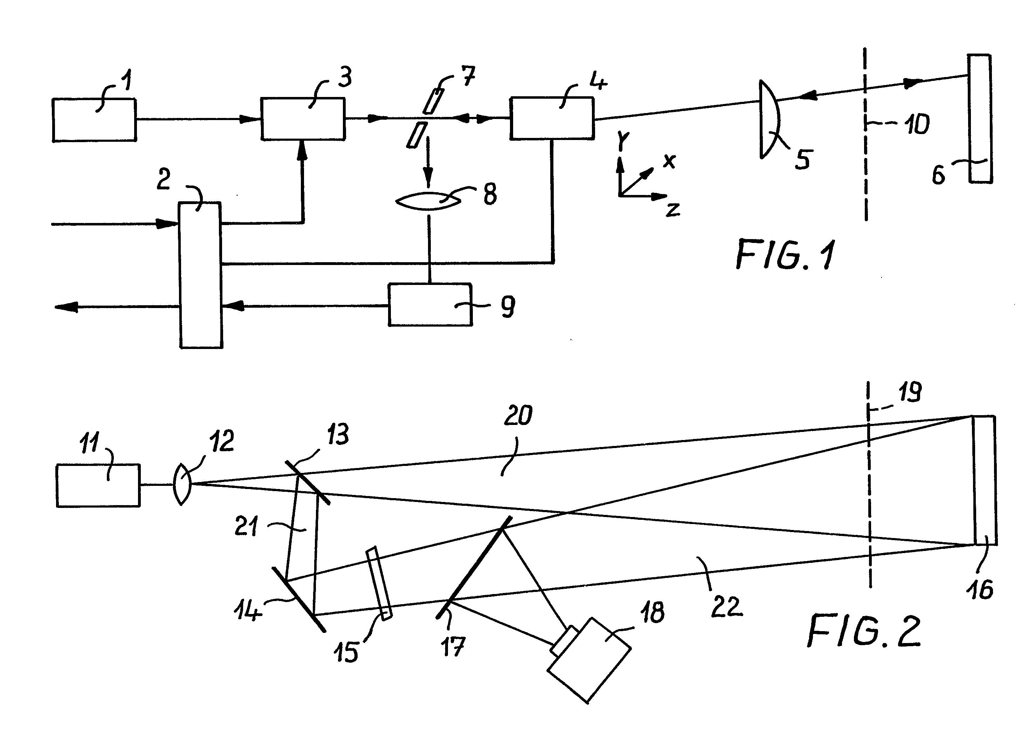

In Fig. 2 besteht die stationäre Schreibe-/Lesevorrichtung linksseitig der Linie 19 aus einem Laser 11, einer Vorrichtung zur Erzeugung holographischer Bilder, bestehend aus einer Mikrolinse 12, einem Strahlteiler 13, einem Spiegel 14 sowie einem Informationsträger 15 und einer Auswertevorrichtung mit den Komponenten klappbarer Spiegel 17 und einer Videokamera 18. Rechtsseitig der gestrichelten Linie 19 ist das optische Speichermodul 16.

Für die Speicherung von transformierten Daten, die in ihrer Gesamtheit ein Hologram bilden, wird der im Laser 11 erzeugte Laserstrahl mit der Mikrolinse 12 aufgeweitet und mit dem Strahlungsteiler 13 in Referenzstrahl 20 und Objektstrahl 21 aufgeteilt. Die zu speichernden Daten befinden sich auf dem Informationsträger 15, das von dem durch Spiegel 14 umgelenkten Objektstrahl 21 durchleuchtet wird.

Der klappbare Spiegel 17 ist aus dem Strahlgang des modifizierten Objektstrahls 22 weggeklappt. Das optische Speichermodul 16 fixiert das von Referenzstrahl 20 und modifiziertem Objektstrahl 22 erzeugte Interferenzmuster.

Beim Lesevorgang wird das optische Speichermodul 16 durch den Referenzstrahl 20, erzeugt durch Laser Mikrolinse 12 und dem auf transparent gehalteten Strahlteiler 13, beleuchtet. Das vom Speichermodul 16 remittierte Licht wird mit Hilfe des klappbaren Spiegels 17 in die Videokamera 18 umgelenkt und steht dort als elektrisches Signal für eine Auswertung zur Verfügung.

**Ansprüche**

1. Verfahren zur berührungslosen optischen Übertragung von Daten zwischen jeweiligen Sender-und Empfängerkombinationen, die eine Datenauswertung besitzen und einem nicht flüchtigen optisch·aktivierbaren reversiblen passiven Speicher,
**dadurch gekennzeichnet,**
daß die Daten durch Laserlicht in den Speicher in Form von Fourier-Hologrammen eingelesen und durch Reflektion herausgelesen werden.

2. Verfahren zur berührungslosen optischen Übertragung von Daten zwischen jeweiligen Sender-und Empfängerkombinationen, die eine Datenauswertung besitzen, und einem nicht flüchtigen optisch aktivierbaren reversiblen passiven Speicher zur Kennzeichnung und Identifizierung von Werkzeugen und/oder Werkstücken, dadurch gekennzeichnet, daß die Daten durch Laserlicht in den Speicher in Form von Fourier-Hologrammen eingelesen und durch Reflektion herausgelesen werden.

3. Verfahren nach den Ansprüchen 1 und 2, dadurch gekennzeichnet, daß ein Weißlicht-Fourier-Hologramm gespeichert wird.

4. Verfahren nach den Ansprüchen 1 bis 3, dadurch gekennzeichnet, daß ein Volumenhologramm gespeichert wird.

5. Verfahren nach den Ansprüchen 1 bis 4, dadurch gekenzeichnet, daß die transformierten Daten, die in ihrer Gesamtheit das Hologramm bilden, mit Hilfe einer Steuerung in Form einer Leistungsmodulation auf den Laserstrahl moduliert werden.

6. Verfahren nach Anspruch 5, dadurch gekennzeichnet, daß der Laserstrahl durch eine vor der aktiven Speicherfläche angeordnete Schicht auf mehrere Bereiche der Speicherfläche fokussiert wird.

7. Verfahren nach Anspruch 6, gekennzeichnet durch eine Schicht, mit einer Oberflächenstruktur, die eine Vielzahl von Linsen, vorzugsweise sphärische Linsen bildet.

8. Verfahren nach den Ansprüchen 6 und 7, dadurch gekennzeichnet, daß die Schicht unterschiedliche Brechungsindizes aufweist.

9. Verfahren nach einem der Ansprüche 1 bis 8, dadurch gekennzeichnet, daß die transformierten Daten, die in ihrer Gesamtheit das Hologramm bilden, in Rasterform durch Verschiebung des Laserstrahlbündels senkrecht zu seiner Ausbreitungsrichtung gespeichert werden.

1O. Verfahren nach einem der Ansprüche 1 bis 4, dadurch gekennzeichnet, daß ein Informationsträger in Form von Dias, Transparenten, Flüssigkristalldisplays holographisch auf dem Speicher abgebildet wird.

11. Verfahren nach einem der Ansprüche 1 bis 4, dadurch gekennzeichnet, daß ein Transmissions-Hologramm holographisch auf dem Speicher rekonstruiert wird.

12. Verfahren nach Anspruch 4, dadurch gekennzeichnet, daß die Hologramme dreidimensional gespeichert und gelesen werden.

13. Verfahren nach Anspruch 2, dadurch gekennzeichnet, daß akustooptische Deflektoren verwendet werden.

14. Vorrichtung zur Durchführung des Verfahrens nach den Ansprüchen 1 bis 13, bestehend aus einer optischen Sender-und Empfängerkombination mit Datenauswertung und einem nicht flüchtigen passiven reversiblen Speicher, gekennzeichnet durch eine Sender-Empfängerkombination mit Modulationsvorrichtungen zur Selektion und Scannervorrichtungen zur punktweisen Ansteuerung des Speichers.

15. Vorrichtung nach Anspruch 14, dadurch gekennzeichnet, daß zur Modulation dem Laser ein akustooptischer Modulator nachgeschaltet ist.

16. Vorrichtung nach Anspruch 14, dadurch gekennzeichnet, daß vor dem Speicher eine nicht planparallele Schicht, vorzugsweise unterschiedlicher Dicke oder Brechungsindizes, angeordnet ist.

17. Vorrichtung nach Anspruch 16, dadurch gekennzeichnet, daß die Schicht aus zusammenhängenden sphärischen und/oder zylindrischen Linsen, vorzugsweise unterschiedlicher Brennweite, besteht.

18. Vorrichtung nach Anspruch 14, dadurch gekennzeichnet, daß dem Laser ein akustooptischer Deflektor nachgeschaltet ist.

19. Vorrichtung nach einem der Ansprüche 16 bis 18, dadurch gekennzeichnet, daß der Speicher in der Tiefe rasterartig aufgebaute optisch aktivierbare Plätze aufweist.

2O. Vorrichtung nach Anspruch 14, dadurch gekennzeichnet, daß zur Auswertung der aus dem Speicher remittierten Strahlung eine Registriervorrichtung, z. B. ein Photoelement, eine Videokamera oder ein CCD-Bauelement 1O vorgesehen sind.

*FIG.1*

*FIG.2*